(19)

Europäisches
Patentamt
European
Patent Office
Office européen
des brevets

(11) **EP 1 371 087 B1**

(12) **EUROPEAN PATENT SPECIFICATION**

(45) Date of publication and mention
of the grant of the patent:
**17.11.2010 Bulletin 2010/46**

(21) Application number: **02713331.3**

(22) Date of filing: **22.03.2002**

(51) Int Cl.:
*H01L 21/205* (2006.01)      *C30B 25/10* (2006.01)
*C30B 25/12* (2006.01)

(86) International application number:
**PCT/SE2002/000560**

(87) International publication number:
**WO 2002/078070 (03.10.2002 Gazette 2002/40)**

(54) **A DEVICE FOR EPITAXIALLY GROWING OBJECTS BY CVD**

VORRICHTUNG ZUM EPITAKTISCHEN WACHSTUM MITTELS CVD

DISPOSITIF DESTINE A LA CROISSANCE EPITAXIALE D'OBJETS PAR CVD

(84) Designated Contracting States:
**AT BE CH CY DE DK ES FI FR GB GR IE IT LI LU
MC NL PT SE TR**

(30) Priority: **23.03.2001 SE 0101012**

(43) Date of publication of application:
**17.12.2003 Bulletin 2003/51**

(73) Proprietor: **CREE, INC.
Durham, NC 27703 (US)**

(72) Inventors:
• **LIU, Yuijing
S-723 46 Västerås (SE)**
• **LÖFGREN, Peter
S-723 53 Västerås (SE)**

• **HALLIN, Christer
S-583 31 Linköping (SE)**
• **ZHOU, Gang
S-722 42 Västerås (SE)**

(74) Representative: **Olsson, Jan et al
Bjerkéns Patentbyrå KB
P.O.Box 1274
801 37 Gävle (SE)**

(56) References cited:
**EP-A1- 0 748 881      US-A- 4 632 058
US-A- 5 695 567      US-A- 5 888 303**

• **PATENT ABSTRACTS OF JAPAN vol. 16, no. 4 (E-1151) 08 January 1992 & JP 03 228 319 A (NKK CORP) 09 October 1991**

**Description**

TECHNICAL FIELD OF THE INVENTION AND PRIOR ART

The present invention relates to a device for epitaxially growing objects by Chemical Vapour Deposition on substrates comprising a casing defining a room for receiving a holder carrying a plurality of substrates and adapted to be rotated about a substantially vertical axis, means for rotating said holder during the growth, means for feeding a gas mixture for the growth into said room through an inlet being directed substantially along said vertical axis and means for heating said gas mixture inside said room for decomposition thereof and depositing of particles so formed on the substrates for growing layers thereon in a substantially vertical direction for said growth.

The invention relates to all types of objects grown on substrates in that way, but it is in particular directed to the growth of layers to be used for semiconductor devices and especially to growth of materials putting high demands upon accuracy of the growth process, such as high quality crystalline layers of SiC for use in power semiconductor devices. This particular application of the invention will therefore be discussed hereinafter without limiting the invention thereto.

When growing such objects by Chemical Vapour Deposition it is not possible to obtain a growth being interesting from the commercial point of view should only one object at the time be grown on one single substrate, since that would mean that it would take hours to produce one single object or wafer. Devices of the type defined in the introduction have for that sake been developed for growing a number of such wafers in the same run.

It is known to have a substantially horizontal inlet into the growth room of such a device, in which the holder of the substrates rotates about a substantially vertical axis and the substrates themselves, arranged close to the periphery of a circular disc of the holder, rotate about their own axis, a so called horizontal planetary reactor. However, in this type of device the gases (the precursors) of the gas mixture needed for said growth are depleted in the longitudinal direction of the flow path through the growth room. It will result in a lower growth rate and more severely it will not be enough for obtaining a uniform growth that the holder rotates, but stresses and irregularities will be built in into the wafers.

A device of the type defined in the introduction having a substantially vertical inlet adapted to introduce a gas mixture into the room from above onto a holder for being diverted radially and sweeping over the substrates on the holder rapidly rotating is also known, for instance by US-A-5 888 303. However, the quality of the material grown in such devices already known is not sufficient, since it is difficult to obtain a temperature distribution inside the room being sufficiently uniform and the background impurity level is too high. Heating coils are in these devices built in into said casing directly under the holder disc for heating the gas mixture through heating of the holder, which limits the pressure regime it is desired to work within owing to the risk of arcing problems.

SUMMARY OF THE INVENTION

The object of the present invention is to provide a device of the type defined in the introduction, which makes it possible to grow a plurality of said objects or wafers in the same run while ensuring a high crystalline quality thereof.

This object is according to the invention obtained by providing such a device according to the appended claim 1.

This results in a number of advantages. By heating the substrates and said gas mixture mainly by radiation from the susceptor being fixed it will be easier to shield the rotation mechanism from heat transfer and obtain a uniform temperature distribution within said room. This results in a possibility to produce a plurality of wafers at a comparatively high growth rate in the same run and with a high crystalline quality. By providing a flow path according to said formula a velocity of the gases will be substantially the same in the entire flow path resulting in uniform growth conditions and high quality of substates grown. A device of another type than defined in the introduction showing this is known through JP-A-03228312. Furthermore tapering extension of the flow path will counteract a loss of velocity of the gas mixture further away from the inlet owing to the increase of the horizontal dimension of the flow path. Accordingly, the supply of components for the growth will be more uniformly distributed in the radial direction resulting in a higher quality of the material grown.

According to a preferred embodiment of the invention said heating means is arranged outside the casing. This is made possible by using the walls of the susceptor having a substantial thickness for transferring heat to the substrates and the gas mixture inside the room, and the system (the room inside the casing) will be cleaner thanks to this arrangement of the heating means, so that less undesired impurities will be introduced into the layer grown on the substrates.

According to another preferred embodiment of the invention the susceptor walls are made of graphite, which is a material well suited for obtaining a uniform heating of the walls, especially through inductive heating.

According to another preferred embodiment of the invention the device has an inlet adapted to introduce a gas mixture into said room from below, said holder is arranged to hold substrates on top thereof, the holder is fixed to a rotating axle being hollow for defining an inlet for said gas mixture into said room through the hollow holder axle, and a further inlet from above is arranged for introducing colder gas through that inlet from above. The introduction of said colder gas from the opposite direction to the direction of introduction of the gas mixture for the growth will prevent that particles formed when precursor gases of the gas mixture are decomposed will deposit on the ceiling of the susceptor and not on the substrates.

According to another preferred embodiment of the invention the device has an inlet for said gas mixture into said room both from above and from below, and said holder is adapted to hold said substrates on top as well as on the lower side thereof. This results in a doubled production rate making it possible to substantially reduce the costs of the wafers grown and making the growth process commercially more competitive.

According to another preferred embodiment of the invention said inlet is provided with means for defining substantially concentric ring inlet channels for separate flows of gases into said room, and said outermost ring channel is adapted to receive a carrier gas not preheated for flowing closest to the susceptor wall in question in said room. Such a division of the flow entering the room for said growth results in a protection of the walls, ceiling or bottom, of the susceptor against deposition of species formed through decomposition of the precursor gases and depleting the gases needed for the growth.

According to another preferred embodiment of the invention constituting a further development of the embodiment last mentioned the device comprises at least three said ring channels and said feeding means is adapted to feed the entire amount of said gas mixture through a said ring channel being intermediately located as seen in the radial direction. This means that other gases, carrier gases, will enter into the room through a ring channel being more centrally located than the ring channel for said gas mixture making it possible to obtain a more uniform deposition of species on the substrates, in particular if the central flow will be preheated resulting in an even temperature profile inside the room.

According to another preferred embodiment of the invention the device is adapted for growing wafers of crystalline SiC on top of said substrates, in which said heating means is preferably adapted to heat the susceptor and by that the substrate and said gas mixture to a temperature exceeding 1200°C, preferably exceeding 1400°C. A device of this type is particularly suited for the growth of layers of SiC putting very high demands on crystalline quality for making it possible to fully benefit from the superior properties of SiC with respect to breakdown field strength, high temperature stability etc, compared to for instance Si and making the material interesting to use in high power semiconductor devices.

Further advantages as well as advantageous features of the invention appear from the following description and the other dependent claims.

BRIEF DESCRIPTION OF THE DRAWINGS

With reference to the appended drawings, below follows a specific description of preferred embodiments of the invention cited as examples.

In the drawings:

Fig 1 is a simplified cross-section view of a device according to a first preferred embodiment of the invention in the form of a hot-wall rotating vertical CVD-reactor,

Fig 2 is a partial view corresponding to Fig 1 of a device according to a second preferred embodiment of the invention,

Fig 3 is a view corresponding to Fig 1 of a device according to a third preferred embodiment of the invention,

Fig 4 is a view corresponding to Fig 1 of a device according to a fourth preferred embodiment of the invention,

Fig 5 is a view corresponding to Fig 2 of a device according to a fifth preferred embodiment of the invention, and

Fig 6 is a view of the inlet of the device according to Fig 5 as seen in the direction of VI-VI in Fig 5.

DETAILED DESCRIPTION OF PREFERRED EMBODIMENTS OF THE INVENTION

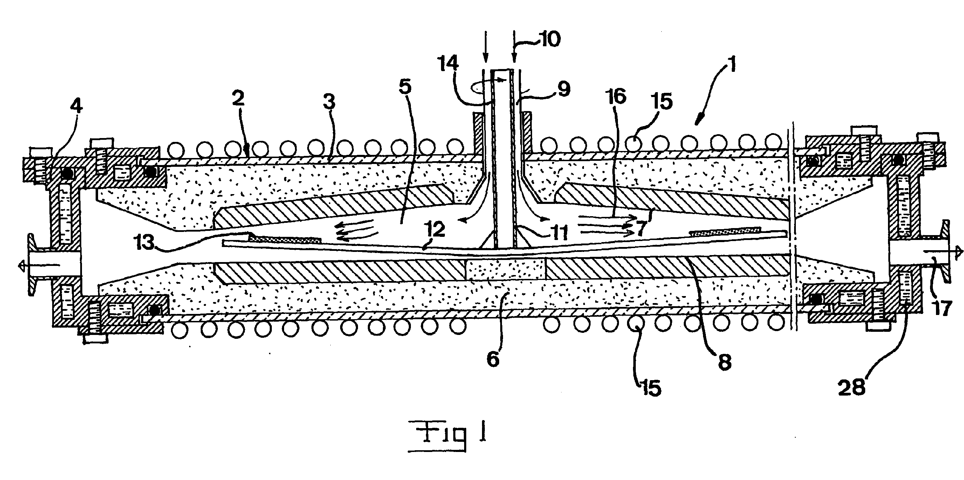

A reactor 1 for epitaxially growing objects, especially of SiC, by Chemical Vapour Deposition is schematically shown in fig 1 for explaining the principals of the invention. The reactor 1 comprises a casing 2 constituted by an outer wall 3 of quartz and end flanges 4 of stainless steel. The casing 2 delimits an inner volume or room 5 in which vacuum is created by pumps not shown. The reactor further comprises internally of the quartz casing a thermally insulating layer 6, preferably insulating foam. The walls (ceiling 7 and bottom 8 are included in this definition) closest to said room 5 are made of graphite having a substantial thickness, so that these walls 7, 8 form a so-called hot-wall susceptor. The casing 2 has also a substantially vertical inlet 9 into the room 5 from above and means 10 indicated by arrows for feeding a gas mixture of precursor gases, for the growth of SiC C- and Si-containing gases, such as propane and silane, and a carrier gas, such as $H_2$, into the room.

The device also comprises a holder constituted by a disc-like member 12 close the periphery of which substrates 13 are arranged and which is centrally connected to an axle 14 adapted to be rotated around the longitudinal axis thereof for rotating the holder 11 with the substrates 13 inside the room 5 during the growth. The substrates 13 is in the case of growing SiC preferably made of crystalline SiC, Si or any group III-nitride.

The device also comprises heating means 15 in the form of two so-called pancake Rf-field radiating coils wound around said vertical axis on the top of and under the casing 2. Thanks to the fact that the casing 2 is made of quartz, it will be permeable to said Rf-field. The susceptor is furthermore preferably coated by SiC, at least close to the substrates 13, for preventing impurities in the graphite of the susceptor from being released into the room 5 and be incorporated into the epitaxial layers of the substrate. The heating means will by said Rf-field heat the thick susceptor walls 7 and 8 of graphite and by radiation therefrom the substrates and the gas mixture entering the room through the inlet 9. It is advantageous that the heating part (the susceptor walls 7, 8) is separated from the rotating part (the holder disc-like member 12) making it easier to obtain a uniformous temperature inside the room 5. As mentioned above, it is also advantageous that the heating means is arranged outside the casing resulting in a cleaner system. It is indicated by 28 that channels for circulating water are arranged in the end flanges 4 for cooling purposes. This device and the devices according to the other embodiments described below are substantially symmetrical with respect to rotation about the vertical centre axis.

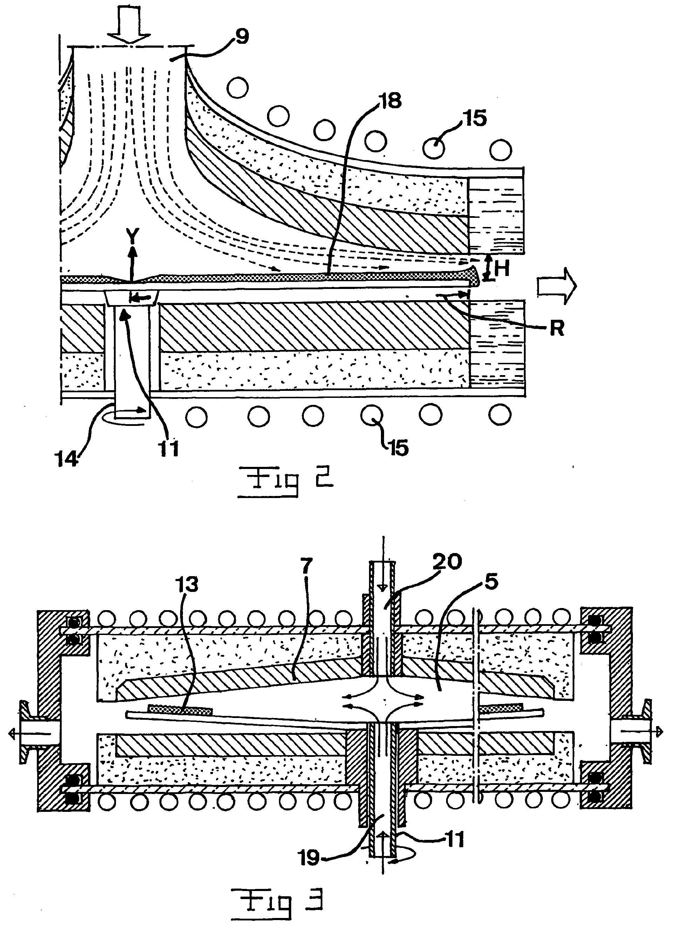

It is shown how the flow path 16 for said gas mixture entering the room through the inlet 9 is delimited in the radial direction towards radial outlets 17 through the disc-like member 12 and the ceiling 7 in such a way that it tapers radially by a reduction of the distance between said disc-like member and the ceiling. This is advantageous for a uniform deposition on the substrates for said growth, since this will result in a substantially uniform radial velocity of the gas mixture. It has especially turned out that it is preferred that the height Y of the flow path satisfies the formula

$$Y = RH/x,$$

in which R is the radius of said room 5 between the centre inlet and a radial outlet 17 thereof, H is said height at said outlet and x is the radial distance from the centre axis for said inlet as illustrated in the embodiment according to Fig 2 differing from the one according to Fig 1 substantially by the fact that the axle 14 of the holder 11 enters the susceptor room from below. It is in Fig 2 illustrated that the disc-like member extends substantially horizontally, whereas it in the embodiment according to Fig 1 makes a small angle to the horizontal. This design rule of the flow path will reduce the non-useful deposition in the somewhat colder area close to the rotating axis, where a straight ceiling wall will give fast speed of the gases. In this way, the ceiling wall according to Fig 2 will reduce the depletion in upstream area on the substrates 13 and end out higher growth rates at the wafer and a uniform film 18 grown thereon.

This type of reactor is used for growing films with a thickness of 1-50 $\mu$m for the use in primarily high power semiconductor devices. The heating means 15 will heat the susceptor walls and by radiation therefrom the substrate and the gas mixture entering the room to a temperature of preferably 1500-1600°C, so that the precursor gases are cracked and in the case of growing SiC the Si- and C-atoms so formed are deposited onto the substrates 13 while forming well ordered epitaxial layers thereon. By rotating the substrate holder and said design of the flow path substantially uniform growth conditions will be provided for the substrates, so that the layers grown on the different substrates will have substantially the same properties. This is also valid for the doping of the layers obtained by adding dopants, such as Al, B, N and the like to the gas mixture.

A device according to a third preferred embodiment of the invention is schematically illustrated in Fig 3, and this differs from that according to Fig 1 by the fact that the holder 11 is fixed to a rotating axle 14 being hollow for defining an inlet 19 for the gas mixture into the room 5. Furthermore, a second inlet 20 is arranged from above for introducing colder gas through that inlet from above, and this colder gas will protect the ceiling 7 against deposition of atoms resulting from the precursor gases decomposed in the room 5 preventing the substantially radial gas flow from being gradually more and more depleted on the way to the substrates 13.

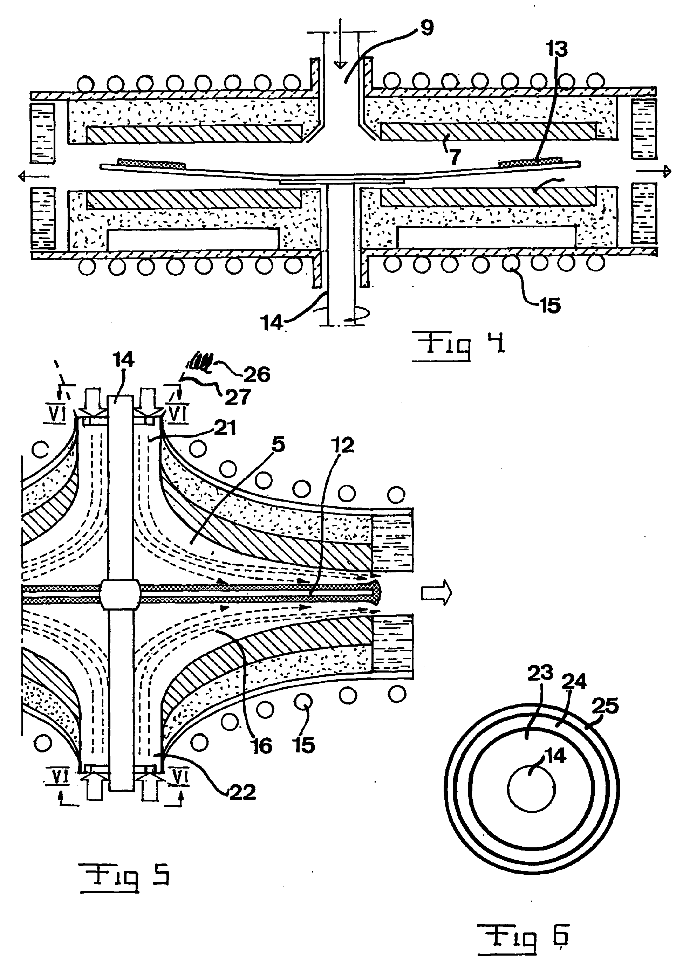

A device according to a fourth preferred embodiment of the invention is schematically illustrated in Fig 4. This device constitutes a slight modification of the device shown in Fig 2 not requiring any further explanation.

Fig 5 illustrates a device according to a fifth preferred embodiment of the invention having a design similar to the one of the device shown in Fig 2, but it has an inlet 21, 22 of gases for the growth both from above and below for growing epitaxial layers both on the top of the disc-like holder member 12 and on the underside thereof. Thus, a doubling the production rate of the device is achieved. Furthermore, it appears especially from Fig 6 that the inlets of this device has a particular design with three ring channels 23-25 being substantially concentrically arranged around the axle 14. The device may also comprise means 26 (very schematically indicated for the upper inlet 21 but also being there for the lower inlet) for preheating the gases before entering the room 5 through the respective inlet. By preheating the gases it may be avoided that a lower temperature zone is caused in the central area of the cross-section of the susceptor resulting in a vertical temperature gradient, which may influence the growth rate and the quality of the layers grown. Such a lower temperature zone would also cause horizontal temperature gradient on the susceptor surface, which results in a long path for gas to reach a desirable temperature for the deposition. This long temperature gradient path either increases severe depletion of precursor or causes a silicon-rich (when growing SiC) deposition. Preheating avoids this. However, if preheating is made for a gas mixture of precursor gases and carrier gases a pregrowth area of bad morphology SiC will be formed and therefore deplete the precursors. The device of the present invention shown in Fig 5 has solved this problem by dividing the gases at the inlet 21 into three different flows in the ring channels 23-25. In the outermost ring 25 a small amount of carrier gas being not preheated is introduced and it will prohibit deposition of precursor gases cracked on the ceiling of the susceptor. In this manner a larger part of the precursors being introduced through the mid ring channel 24 together with a medium amount of carrier gas and being medium preheated can effectively be used for the epitaxial growth. A larger amount of carrier gas being preheated is introduced through the inner ring channel 23. By preheating the larger part of the flow (entering through the ring channels 23 and 24) an even temperature profile in the room 5 can be achieved.

Furthermore, it is shown for the upper inlet 21 that the inlets may be provided with means 27 adapted to reduce the cross-section of a path for preheated gases before entering the inlet for increasing the velocity of the gases and removing possible turbulences caused by the preheating before entering the room 5.

The invention is of course not in any way restricted to the preferred embodiments described above, but many possibilities to modifications thereof will be apparent to a person having ordinary skill in the art without departing from the basic idea of the invention as defined in the appended claims.

It would for example be possible to modify the device according to Fig 5 so that growth is only taking place on the underside of the holder disc 12.

It would also be possible to grow quite different materials than those mentioned above for exemplifying purposes.

"Gas mixture" is in this disclosure defined as a mixture of gases at least including precursor gases for the growth and possibly also other gases as carrier gases and dopants.

## Claims

1.   A device for epitaxially growing objects by Chemical Vapour Deposition on substrates comprising a casing (2) defining a room (5), a holder (11) received in said room for carrying a plurality of substrates (13) and adapted to be rotated about a substantially vertical axis, means for rotating said holder during the growth, means (10) for feeding a gas mixture for the growth into said room through an inlet (9, 19, 21, 22) being directed substantially along said vertical axis and means (15) for heating said gas mixture inside said room for decomposition thereof and depositing of particles so formed on the substrates for growing layers thereon in a substantially vertical direction for said growth, wherein said room (5) extends radially from said inlet (9, 19, 21, 22 being centrally arranged, those of said susceptor walls (7, 8) forming the ceiling (7) or the bottom (8) of the susceptor and said holder (11) define a flow path (16) for said gas mixture from the inlet and radially along the holder (11) past the substrates (13) tapering radially by a reduction of the distance between the lower and upper limitation of said path in the radial direction, **characterized in that** said room is delimited by a susceptor having fixed walls (7, 8) of a substantial thickness, that said heating means is adapted to heat said susceptor walls for heating said gas mixture substantially through radiation from the hot susceptor walls, and **in that** said tapering expressed as the vertical dimension of said flow path, i.e. the height Y thereof, is substantially according to the formula $Y = RH/x$, in which R is the radius of said room between the centre inlet and a radial outlet thereof, H is said height at said outlet and x is the radial distance from the centre axis for said inlet..

2.   A device according to claim 1, **characterized in that** the holder (11, 12) extends substantially horizontally from the rotation axis thereof radially in said room (5), and that the ceiling or bottom of the susceptor defining said flow path is coming closer to the holder in the radial direction away from said axis.

3.   A device according to claim 1 or 2, **characterized in that** said heating means (15) is arranged outside the casing (2).

4.   A device according to any of claims 1-3, **characterized in that** said heating means (15) is arranged to heat the susceptor walls (7, 8) by radiating an Rf-field inducing currents in said walls.

5.   A device according to any of the preceding claims, **characterized in that** said susceptor walls (7, 8) are made of graphite.

6.   A device according to any of the preceding claims, **characterized in that** said inlet (9, 21) is adapted to introduce said gas mixture from above, and that the substrates (13) are arranged on top of the holder.

7.   A device according to any of claims 1-6, **characterized in that** it has an inlet (19, 22) adapted to introduce a said gas mixture into said room (5) from below.

8.   A device according to claim 7, **characterized in that** said holder (11, 12) is arranged to hold substrates on top thereof, and that the holder is fixed to a rotating axle being hollow for defining an inlet (19) for said gas mixture into said room through the hollow holder axle.

9.   A device according to claim 7, **characterized in that** it has a further inlet (20) from above for introducing colder gas through that inlet from above.

10. A device according to any of the preceding claims, ***characterized*** **in that** it has an inlet (21, 22) for said gas mixture into said room both from above and from below, and that said holder (12) is adapted to hold said substrates on top as well as on the lower side thereof.

11. A device according to claim 10, ***characterized*** **in that** a radial flow path (16) defined above and below said holder are both radially tapering.

12. A device according to any of the preceding claims, ***characterized*** **in that** said inlet is provided with means for defining substantially concentric ring inlet channels (23-25) for separate flows of gases into said room (5), and that said outermost ring channel (25) is adapted to receive a carrier gas not preheated for flowing closest to the susceptor wall (7, 8) in question in said room.

13. A device according to claim 12, ***characterized*** **in that** it comprises at least three said ring channels (23-25) and that said feeding means is adapted to feed the entire amount of said gas mixture through a said ring channel (24) being intermediately located as seen in the radial direction.

14. A device according to any of the preceding claims, ***characterized*** **in that** it comprises means (26) for preheating said gas mixture upstream of said inlet (21, 22) into said room.

15. A device according to claim 14, ***characterized*** **in that** it comprises means (27) adapted to reduce the cross section of a path for preheated gases before entering said inlet (21, 22) for increasing the velocity of the gases and removing possible turbulences before entering said room (5).

16. A device according to any of the preceding claims, ***characterized*** **in that** it is adapted for growing wafers of crystalline SiC on top of said substrates.

17. A device according to claim 16, ***characterized*** **in that** said heating means is adapted to heat the susceptor (7, 8) and by that the substrate (13) and said gas mixture to a temperature exceeding 1200°C.

18. A device according to claim 16, ***characterized*** **in that** said heating means is adapted to heat the susceptor (7, 8) and by that the substrate (13) and said gas mixture to a temperature exceeding 1400°C.

## Patentansprüche

1. Vorrichtung für das epitaktische Aufwachsen von Objekten durch chemische Gasphasenabscheidung auf Substraten, umfassend ein Gehäuse (2), das einen Raum (5) definiert, einen in dem Raum aufgenommenen Halter (11) zum Tragen einer Mehrzahl an Substraten (13), der für die Rotation um eine im Wesentlichen vertikale Achse ausgelegt ist, Mittel für die Rotation des Halters während des Aufwachsens, Mittel (10) für die Zuführung einer Gasmischung für das Wachstum in den Raum durch einen Einlass (9, 19, 21, 22) hindurch, welcher im Wesentlichen entlang der vertikalen Achse ausgerichtet ist, und Mittel (15) für das Erhitzen des Gasgemisches innerhalb des Raumes, um dieses zu zersetzen und die so gebildeten Partikel auf den Substraten abzulagern, um für das Wachstum in einer im Wesentlichen vertikalen Richtung Schichten auf den Substraten aufwachsen zu lassen, wobei sich der Raum (5) radial von dem zentral angeordneten Einlass (9, 19, 21, 22) erstreckt und diejenigen Suszeptorwände (7,8), welche die Decke (7) oder den Boden (8) des Suszeptors bilden, und der Halter (11) einen Strömungsweg (16) für das Gasgemisch von dem Einlass und radial entlang des Halters (11) an den Substraten (13) vorbei definieren, welcher sich radial, durch Reduktion des Abstandes zwischen der unteren und der oberen Begrenzung des Strömungswages in der radialen Richtung, verjüngt, **dadurch gekennzeichnet, dass** der Raum durch einen Suszeptor begrenzt ist, welcher fest installierte Wände (7, 8) von erheblicher Dicke aufweist, dass das genannte Heizmittel für das Erhitzen der Suszeptorwände ausgelegt ist, um das Gasgemisch im Wesentlichen durch Strahlung von den heißen Suszeptorwänden zu erhitzen, und dass die Verjüngung, ausgedrückt als die vertikale Dimension des Strömungsweges, d. h. der Höhe Y des Strömungsweges, im Wesentlichen der Formel $Y = RH/x$ entspricht, in welcher R der Radius des Raumes zwischen dem zentralen Einlass und einem radialen Auslass des Raumes, H die besagte Höhe an dem Auslass und x der radiale Abstand von der zentralen Achse für den Einlass ist.

2. Vorrichtung nach Anspruch 1, **dadurch gekennzeichnet, dass** sich der Halter (11, 12) im Wesentlichen horizontal von der Rotationsachse des Halters aus radial in dem Raum (5) erstreckt, und dass die Decke oder der Boden des Suszeptors, welche(r) den Strömungsweg definiert, in der radialen Richtung von der Achse weg, näher an den Halter herankommt.

3. Vorrichtung nach Anspruch 1 oder 2, **dadurch gekennzeichnet, dass** das Beizmittel (15) außerhalb des Gehäuses (2) angeordnet ist.

4. Vorrichtung nach einem oder mehreren der Ansprüche 1-3, **dadurch gekennzeichnet, dass** das Heizmittel (15) zum Erhitzten der Suszeptorwände (7, 8) durch Ausstrahlen eines HF-Feldes, welches Ströme in den Wänden induziert, ausgestaltet ist.

5. Vorrichtung nach einem oder mehreren der vorangehenden Ansprüche, **dadurch gekennzeichnet, dass** die Suszeptorwände (7, 8) aus Graphit bestehen.

6. Vorrichtung nach einem oder mehreren der vorangehenden Ansprüche, **dadurch gekennzeichnet, dass** der Einlass (9, 21) für die Einleitung der Gasmischung von oben ausgelegt ist, und dass die Substrate (13) auf der Oberseite des Halters angeordnet sind.

7. Vorrichtung nach einem oder mehreren der Ansprüche 1-6, **dadurch gekennzeichnet, dass** der Einlass (19, 22) für die Einleitung einer Gasmischung von unten in den Raum (5) ausgelegt ist.

8. Vorrichtung nach Anspruch 7, **dadurch gekennzeichnet, dass** der Halter (11, 12) zum Halten von Substraten auf der Oberseite des Halters angeordnet ist, und dass der Halter an einer Rotationsachse befestigt ist, welche hohl ist, um einen Einlass (19) für das Gasgemisch in den Raum durch die hohle Halterachse hindurch zu definieren.

9. Vorrichtung nach Anspruch 7, **dadurch gekennzeichnet, dass** sie einen weiteren Einlass (20) von oben, für die Einleitung von kühlerem Gas von oben, durch diesen Einlass hindurch aufweist.

10. Vorrichtung nach einem oder mehreren der vorangehenden Ansprüche, **dadurch gekennzeichnet, dass** sie eignen Einlass (21, 22) aufweist für die Einleitung des Gasgemisches in den Raum sowohl von oben wie auch von unten, und dass der Halter (12) für das Halten der Substrate sowohl auf seiner Oberseite als auch auf seiner Unterseite ausgelegt ist.

11. Vorrichtung nach Anspruch 10, **dadurch gekennzeichnet, dass** sich beide, über und unter dem Halter definierten radialen Strömungswege (16) radial verjüngen.

12. Vorrichtung nach einem oder mehreren der vorangehenden Ansprüche, **dadurch gekennzeichnet, dass** der Einlass mit Mitteln für die Bildung im Wesentlichen konzentrischer ringförmiger Einlasskanäle (23-25) für getrennte Gasströme in den Raum (5) hinein versehen sind, und dass der äußerste ringförmige Kanal (25) für die Aufnahme eines nicht vorgeheizten Trägergases ausgelegt ist, so dass dieses in dem geringsten Abstand von der betreffenden Suszeptorwand (7, 8) in dem Raum strömt.

13. Vorrichtung nach Anspruch 12, **dadurch gekenn-**

**zeichnet, dass** sie wenigstens drei Ringkanäle (23-25) umfasst, und dass das Zuführungsmittel für die Zuführung der gesamten Menge der Gasmischung durch einen ringförmigen Kanal (24) ausgelegt ist, welcher in der radialen Richtung gesehen intermediär angeordnet ist.

14. Vorrichtung nach einem oder mehreren der vorangehenden Ansprüche, **dadurch gekennzeichnet, dass** sie Mittel (26) für das Vorheizen des Gasgemisches vor dem Einlass (21, 22) in den Raum umfasst.

15. Vorrichtung nach Anspruch 14, **dadurch gekennzeichnet, dass** sie Mittel (27) umfasst, die für eine Reduzierung des Querschnitts eines Weges für vorgeheizte Gase vor deren Eintritt in den Einlass (21, 22) ausgelegt sind, um die Geschwindigkeit der Gase zu erhöhen und etwaige Turbulenzen vor dem Eintritt der Gase in den Raum (5) zu beseitigen.

16. Vorrichtung nach einem oder mehreren der vorangehenden Anspräche, **dadurch gekennzeichnet, dass** sie für das Aufwachsen von Wafern aus kristallinem sie auf der Oberseite der Substrate ausgelegt ist.

17. Vorrichtung nach Anspruch 16, dadurch gekennzeichnet, dass das Beizmittel für das Erhitzen des Suszeptors (7, 8) und hierdurch des Substrates (13) und des Gasgemisches auf eine Temperatur von über 1200 °C ausgelegt ist.

18. Vorrichtung nach Anspruch 16, **dadurch gekennzeichnet, dass** das Heizmittel für das Erhitzen des Suszeptors (7, 8) und hierdurch des Substrates (13) und des Gasgemisches auf eine Temperatur von über 1400 °C ausgelegt ist.

**Revendications**

1. Dispositif pour une croissance épitaxiale d'objets par dépôt en phase chimique sur des substrats comportant un boîtier (2) définissant une enceinte (5), un support (11) reçu dans ladite enceinte pour supporter une pluralité de substrats (13) et adapté pour être mis en rotation autour d'un axe en grande partie vertical, des moyens pour mettre en rotation ledit support pendant la croissance, des moyens (10) pour délivrer un mélange gazeux pour la croissance dans ladite enceinte via une entrée (9, 19, 21, 22) étant dirigée en grande partie le long dudit axe vertical et des moyens (15) pour chauffer ledit mélange gazeux à l'intérieur de ladite enceinte en vue de la décomposition de celui-ci et déposer des particules ainsi formées sur les substrats pour faire croître des couches sur ceux-ci dans une direction en grande partie verticale pour ladite croissance, dans lequel ladite enceinte (5) s'étend radicalement depuis ladite entrée (9, 19, 21, 22) étant agencée de manière centrale, celles desdites parois de suscepteur (7, 8) formant le plafond (7) ou la partie inférieure (8) du suscepteur et ledit support (11) définissent un trajet d'écoulement (16) pour ledit mélange gazeux depuis l'entrée et radialement le long du support (11) après les substrats (13) se terminant en pointe radialement par une réduction de la distance entre la limitation inférieure et supérieure dudit trajet dans la direction radiale, **caractérisé en ce que** ladite enceinte est délimitée par un suscepteur ayant des parois fixes (7, 8) d'une épaisseur importante, **en ce que** lesdits moyens de chauffage sont adaptés pour chauffer lesdites parois de suscepteur afin de chauffer ledit mélange gazeux en grande partie à travers le rayonnement depuis les parois de suscepteur chaudes, et **en ce que** ladite terminaison en pointe exprimée en tant que dimension verticale dudit trajet d'écoulement, c'est-à-dire la hauteur Y correspondante, est en grande partie conforme à la formule $Y=RH/x$, dans laquelle R est le rayon de ladite enceinte entre l'entrée centrale et une sortie radiale correspondante, H est ladite hauteur au niveau de ladite sortie et x est la distance radiale depuis l'axe central pour ladite entrée.

2. Dispositif selon la revendication 1, **caractérisé en ce que** le support (11, 12) s'étend en grande partie horizontalement depuis l'axe de rotation de celui-ci radialement dans ladite enceinte (5), et **en ce que** le plafond ou la partie inférieure du suscepteur définissant ledit trajet d'écoulement se rapproche du support dans la direction radiale s'éloignant dudit axe.

3. Dispositif selon la revendication 1 ou 2, **caractérisé en ce que** lesdits moyens de chauffage (15) sont agencés à l'extérieur du boîtier (2).

4. Dispositif selon l'une quelconque des revendications 1 à 3, **caractérisé en ce que** lesdits moyens de chauffage (15) sont agencés pour chauffer les parois de suscepteur (7, 8) en rayonnant un champ Rf induisant des courants dans lesdites parois.

5. Dispositif selon l'une quelconque des revendications précédentes, **caractérisé en ce que** lesdites parois de suscepteur (7, 8) sont constituées de graphite.

6. Dispositif selon l'une quelconque des revendications précédentes, **caractérisé en ce que** ladite entrée (9, 21) est adaptée pour introduire ledit mélange gazeux depuis le dessus, et **en ce que** les substrats (13) sont agencés sur le dessus du support.

7. Dispositif selon l'une quelconque des revendications 1 à 6, **caractérisé en ce que** il a une entrée (19, 22) adaptée pour introduire ledit mélange gazeux dans ladite enceinte (5) depuis le dessous.

8. Dispositif selon la revendication 7, **caractérisé en ce que** ledit support (11, 12) est agencé pour contenir des substrats sur le dessus de celui-ci, et **en ce que** le support est fixé à un axe de rotation étant creux pour définir une entrée (19) pour ledit mélange gazeux dans ladite enceinte à travers l'axe de support creux.

9. Dispositif selon la revendication 7, **caractérisé en ce qu'**il dispose d'une entrée supplémentaire (20) depuis le dessus pour introduire un gaz plus froid via ladite entrée depuis le dessus.

10. Dispositif selon l'une quelconque des revendications précédentes, **caractérisé en ce qu'**il a une entrée (21, 22) pour ledit mélange gazeux dans ladite enceinte à la fois depuis le dessus et depuis le dessous, et **en ce que** ledit support (12) est adapté pour conserver lesdits substrats sur le dessus ainsi que sur le côté inférieur correspondant.

11. Dispositif selon la revendication 10, **caractérisé en ce qu'**un trajet d'écoulement radial (16) défini au-dessus dudit support et un trajet d'écoulement radial défini au-dessous dudit support se terminent tous les deux radialement en pointe.

12. Dispositif selon l'une quelconque des revendications précédentes, **caractérisé en ce que** ladite entrée est munie de moyens pour définir des canaux d'entrée à anneau en grande partie concentrique (23-25) pour des écoulements de gaz séparés dans ladite enceinte (5), et **en ce que** ledit canal à anneau situé le plus à l'extérieur (25) est adapté pour recevoir un gaz porteur non préchauffé pour circuler à proximité maximale de la paroi de suscepteur (7, 8) en question dans ladite enceinte.

13. Dispositif selon la revendication 12, **caractérisé en ce qu'**il comporte au moins trois desdits canaux à anneau (23-25) et **en ce que** lesdits moyens d'alimentation sont adaptés pour alimenter la quantité entière dudit mélange gazeux via ledit canal à anneau (24) étant positionné de manière intermédiaire comme observé dans la direction radiale.

14. Dispositif selon l'une quelconque des revendications précédentes, **caractérisé en ce qu'**il comporte des moyens (26) pour préchauffer ledit mélange gazeux en amont de ladite entrée (21, 22) dans ladite enceinte.

15. Dispositif selon la revendication 14, **caractérisé en ce qu'**il comporte des moyens (25) adaptés pour réduire la section efficace d'un trajet pour des gaz préchauffés avant de pénétrer dans ladite entrée (21, 22) pour augmenter la vitesse des gaz et supprimer des turbulences possibles avant de pénétrer dans ladite enceinte (5).

16. Dispositif selon l'une quelconque des revendications précédentes, **caractérisé en ce qu'**il est adapté pour la croissance de tranches de SiC cristallin sur le dessus desdits substrats.

17. Dispositif selon la revendication 16, **caractérisé en ce que** lesdits moyens de chauffage sont adaptés pour chauffer le suscepteur (7, 8) et donc le substrat (13) et ledit mélange gazeux à une température dépassant 1200 °C.

18. Dispositif selon la revendication 16, **caractérisé en ce que** lesdits moyens de chauffage sont adaptés pour chauffer le suscepteur (7, 8) et donc le substrat (13) et ledit mélange gazeux à une température dépassant 1400 °C.

Fig 1

Fig 2

Fig 3

_Fig 4_

_Fig 5_

_Fig 6_

**EP 1 371 087 B1**

### REFERENCES CITED IN THE DESCRIPTION

**Patent documents cited in the description**

- US 5888303 A

- JP 03228312 A